# EUROPEAN PATENT SPECIFICATION

(11) **EP 2 326 509 B1**
(45) Date of publication and mention of the grant of the patent: **16.07.2014**
(21) Application number: 08782946.1
(22) Date of filing: 19.08.2008
(51) Int. Cl.: H05K 7/02

(54) **PRINTED CIRCUIT BOARD BONDING DEVICE**
LEITERPLATTENVERBINDUNGSVORRICHTUNG
DISPOSITIF DE FIXATION DE CARTE À CIRCUITS IMPRIMÉS

(43) Date of publication of application: 01.06.2011
(73) Proprietor: Zamtec Limited, Dublin 2 (IE)
(72) Inventor: O'FARRELL, Stephen, Richard, Balmain New South Wales 2041 (AU); WASZCZUK, Jan, Balmain New South Wales 2041 (AU); SLEIJPEN, Stephen, John, Balmain New South Wales 2041 (AU); ANDREW, James, Balmain New South Wales 2041 (AU); STRUDWICKE, Craig, Donald, Balmain New South Wales 2041 (AU); GRANGER, William, Balmain New South Wales 2041 (AU); JANOS, Mark, Balmain New South Wales 2041 (AU)
(74) Representative: Moore, Barry
(86) International application number: PCT/AU2008/001198
(87) International publication number: WO 2010/019984

(56) References cited:
- JP-A- 10 321 996
- JP-A- H09 211 484
- JP-A- H09 307 218
- US-A1- 2003 122 897
- US-A1- 2006 087 022
- US-A1- 2007 206 057

## Description

### FIELD OF INVENTION

The present invention generally relates to bonding a flexible printed circuit board (PCB) to integrated circuits, such as that of a printhead.

### BACKGROUND

Pagewidth printers that incorporate micro-electromechanical components generally have printhead integrated circuits that include a silicon substrate with a large number of densely arranged micro-electromechanical nozzle arrangements. Each nozzle arrangement is responsible for ejecting a stream of ink drops.

In order for such printers to print accurately and maintain quality, it is important that the printhead integrated circuits be tested. This is particularly important during the design and development of such integrated circuits.

In order to test such integrated circuits, it is necessary to attach some form of data communication arrangement to the integrated circuits. Flexible printed circuit boards are an example of such a data communication arrangement and have been used to communicate data to integrated circuits. JP H09307218A discloses a terminal interconnecting device comprising two or more independent heater blocks for bonding thermo-compressively the respective terminals of an aligned flexible board to respective board terminals disposed on a plurality of planes including at least one step among every single plane of the plurality of planes.

### SUMMARY OF THE INVENTION

The present teaching provides a bonding device as detailed in claim 1. Advantageous features are provided in dependent claims.

### BRIEF DESCRIPTION OF THE DRAWINGS

Preferred features, embodiments and variations of the invention may be discerned from the following Detailed Description which provides sufficient information for those skilled in the art to perform the invention. The Detailed Description is not to be regarded as limiting the scope of the preceding Summary of the Invention in any way. The Detailed Description will make reference to a number of drawings as follows:
Figure 1 is a perspective view of a flexible printed circuit board (PCB) and a printhead assembly to be bonded, fastened or connected together according to a method of the invention with an apparatus of the invention;
Figure 2 is a perspective view of a bonding device for bonding together the flexible PCB and printhead assembly shown in Figure 1, according to one embodiment of the present invention;
Figure 3 is a perspective view showing the internal bonding parts of the bonding device of Figure 2;
Figure 4 is a perspective view of a carriage of the bonding device of Figure 2 which is configured to carry a carrier on which the printhead assembly is supported for testing purposes;
Figure 5 is a perspective view of a vertical heated platen assembly of the bonding device of Figure 2;
Figure 6 is a perspective view of a horizontal heated platen assembly of the bonding device of Figure 2;
Figure 7 is a functional block diagram of the bonding device of Figure 2;
Figure 8 is a flowchart showing the steps involved with bonding together the flexible PCB and printhead assembly using the bonding device of Figure 2;
Figures 9A-J are schematic side views showing the relative positions of the internal bonding parts of Figure 3 when bonding the flexible PCB to the printhead assembly.
Figure 10 is a power and safety circuit of the bonding device of Figure 2.
Figure 11 is a PLC circuit of the bonding device of Figure 2.
Figure 12 is a heater circuit of the bonding device of Figure 2.
Figure 13 is an air cylinder actuator circuit of the bonding device of Figure 2.
Figure 14 is a pneumatic circuit of the bonding device of Figure 2.

### DETAILED DESCRIPTION OF PREFERRED EMBODIMENTS

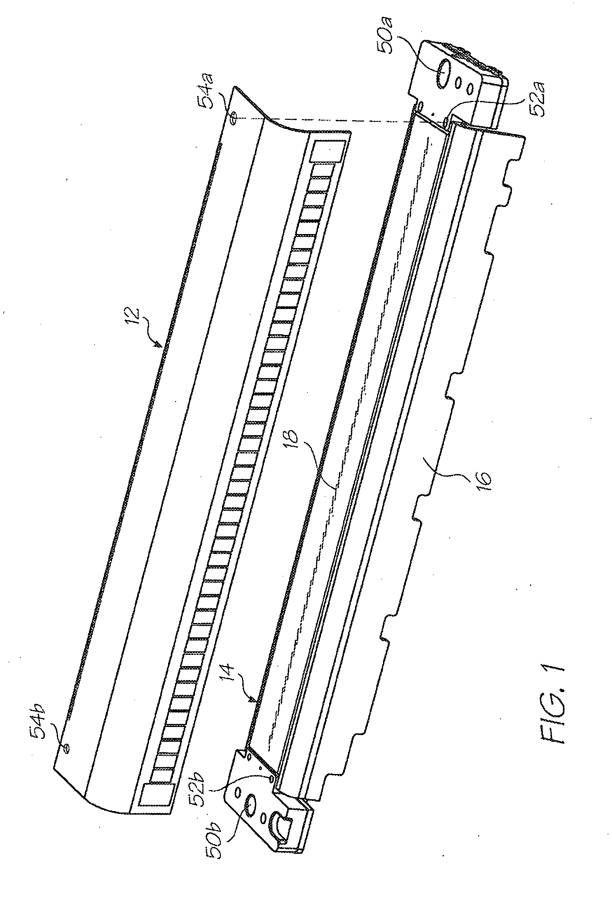

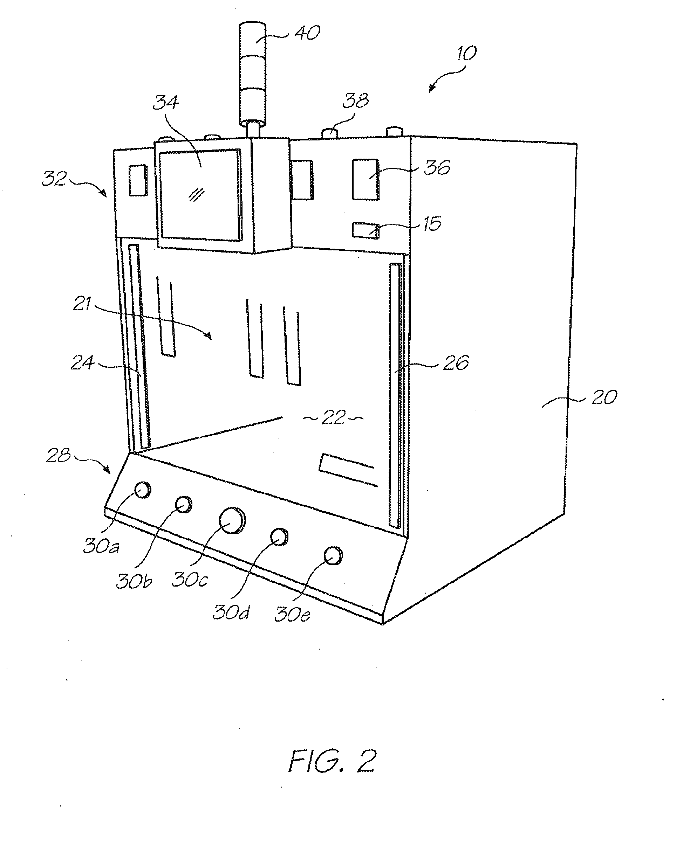

According to an embodiment of the present invention, there is provided a bonding, attachment or fastening device or apparatus 10 shown in Figure 2 which is configured to bond a flexible printed circuit board (PCB) 12 to a printhead assembly 14 as shown in Figure 1. The printhead assembly 14 has a carrier 16. A lamination film is arranged on the carrier 16. An ink ejection printhead 18 is carried on the film.

The film defines a plurality of openings (not shown) which correspond with openings in the printhead 18 and in part of the carrier 16 so that the printhead 18 can be fed with fluid for testing purposes.

The underside of the PCB 12 is coated with an adhesive and the carrier 16 is formed from liquid crystal polymer (LCP) material which is inherently resistant to heat deformation. In use, one or more bonding assemblies, fasteners or connectors or platen assemblies of the bonding device 10 mechanically bond the flexible PCB 12 to the printhead assembly 14 with the adhesive. A detailed description of the bonding device 10 is provided below.

Turning to Figure 2, the bonding device 10 has a housing or support structure assembly that includes a cabinet 20. The cabinet 20 defines an internal space 22 and a front access opening to facilitate operator access to movable bonding parts 21 located in the internal space 22. A light curtain generator is configured to generate a light curtain across the front access opening. The light curtain generator includes an elongate light transmitter 24 mounted to the cabinet on one side of the opening and an elongate light receiver 26 mounted to the cabinet 20 on the other side of the opening. In use, the transmitter 24 transmits a plurality of beams of light which are received by the receiver 26, thereby forming the light curtain.

The bonding device 10 further includes a control system or controller which is configured to cease the operation of the movable bonding parts 21, including the bonding or heater assemblies, responsive to a breach of the light curtain. That is, any movement and heating of the parts 21 is immediately ceased in the event that the operator reaches a hand into the internal space 22, thereby reducing the possibility of injury to the operator.

The cabinet 20 includes an operator control panel 28 located at its base. The control panel 28 includes a row of control press-buttons 30 (i.e. actuators) configured to control the operation of the bonding device 10. The outer press buttons 30a, 30e are START buttons which must be concurrently pressed before the PCB 12 can be bonded to the printhead assembly 14. The controller is configured to control the heater assemblies to bond the PCB 12 to the printhead assembly 14 responsive to the buttons 30a, 30e being concurrently pressed. The START buttons 30a, 30e are spaced apart so that the operator cannot concurrently press both of them using a single hand. In this manner, the operator must have both hands located external to the cabinet 20 when initiating operation of the bonding device 10, thereby ensuring that one hand cannot be located within the cabinet 20.

The bonding device 10 further includes an authentication system for authenticating the printhead assembly 14. The authentication system includes an optical barcode scanner 15 configured to scan barcodes borne by either the printhead 18 or the printhead carrier 16. The scanner 15 is fastened to the cabinet 20, either in the space 22 or on a front panel, and reading of the barcodes is initiated when the operator presses a SCAN press button 30b of the operator control panel 28. The controller is configured to control the heater assemblies to bond the PCB 12 to the printhead assembly 14, only subsequent to the authentication of the printhead assembly 14.

The operator control panel 28 further includes an EMERGENCY STOP button 30c which can be pressed by the operator to cease operation of the bonding device 10 at any time and, in particular, in the event of an emergency. Pressing the EMERGENCY STOP button 30c causes the controller to cease any movement and heating of the heater assemblies. Once the emergency has been addressed, a RESET button 30d of the operator control panel 28 can be pressed to cause the controller to reset the operation of the bonding device 10.

The cabinet 20 also has an upper operator display panel 32. The display panel 32 includes a "touch screen" liquid crystal display (LCD) 34 displaying information relating to the operation of the bonding device 10. The operator can modify operating parameters of the bonding device 10 with a finger, by selecting various options displayed on the LCD 34. The operator display panel 32 further includes a quartet of binary coded decimal (BCD) displays 36 for each displaying the set clamping pressure of a respective clamp or heater assembly of the bonding device 10. A quartet of adjustment knobs 38 are provided on the roof of the cabinet 20 in register with respective BCD displays 36. The set clamping pressure of the internal clamps and heater assemblies can be adjusted by adjusting corresponding adjustment knobs 38.

The bonding device 10 further includes a visible indicator in the form of a light emitting indicator such as a stack of three beacons 40 mounted to the roof of the cabinet 20. The uppermost beacon includes a green light, the intermediate beacon includes an amber light and the bottommost beacon includes a red light. The beacons can be illuminated in a plurality of different ways to represent corresponding operational conditions of the bonding device, the operational conditions including: an occurrence of an operational error with the bonding device 10; a warm up period when the heater assemblies are being warmed up to a threshold operational temperature; a standby mode where the bonding device 10 is ready to initiate operation; and an operational mode where the bonding device 10 is operating.

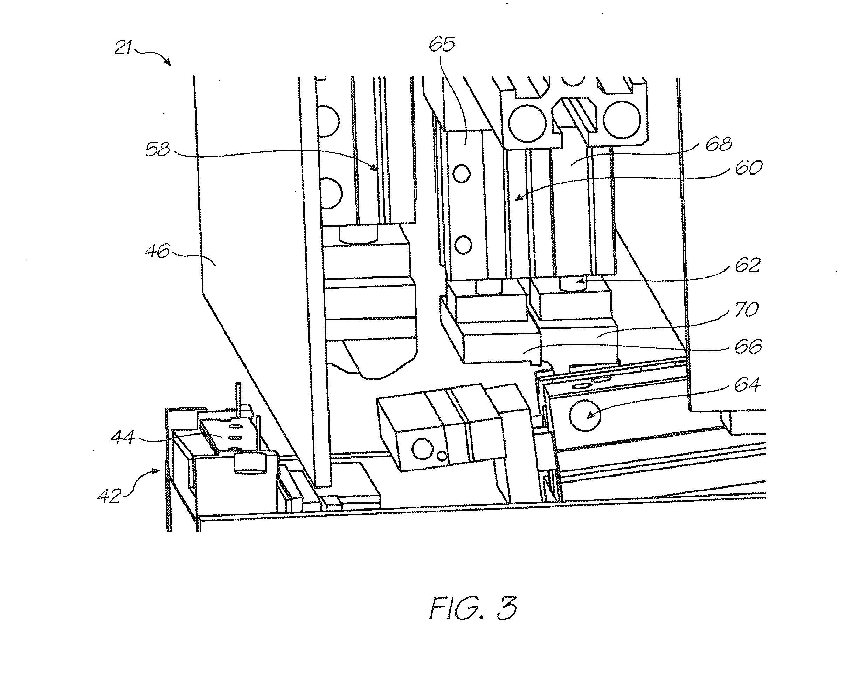

Figure 3 shows the movable bonding parts 21 of the bonding device 10 which are located within the internal space 22 of the cabinet 20. The movable bonding parts 21 include pneumatic actuators which are selectively actuated responsive to control signals from the bonding device controller. A detailed description of the bonding parts 21 is provided below.

The movable bonding parts 21 include a pneumatic carriage 42 which is movably mounted within the cabinet 20 and is configured to carry the printhead assembly 14. The carriage 42 defines a raised nest 44 in which the printhead assembly 14 can be nested. In use, the nest 44 carrying the printhead assembly 14 and PCB 12 can be rectilinearly moved from outside the cabinet 20, to within the space 22 of the cabinet 20 via the front opening (before the light curtain 46 is generated) so that various bonding parts 21 can perform suitable operations to fasten the printhead assembly 14 and PCB 12 together.

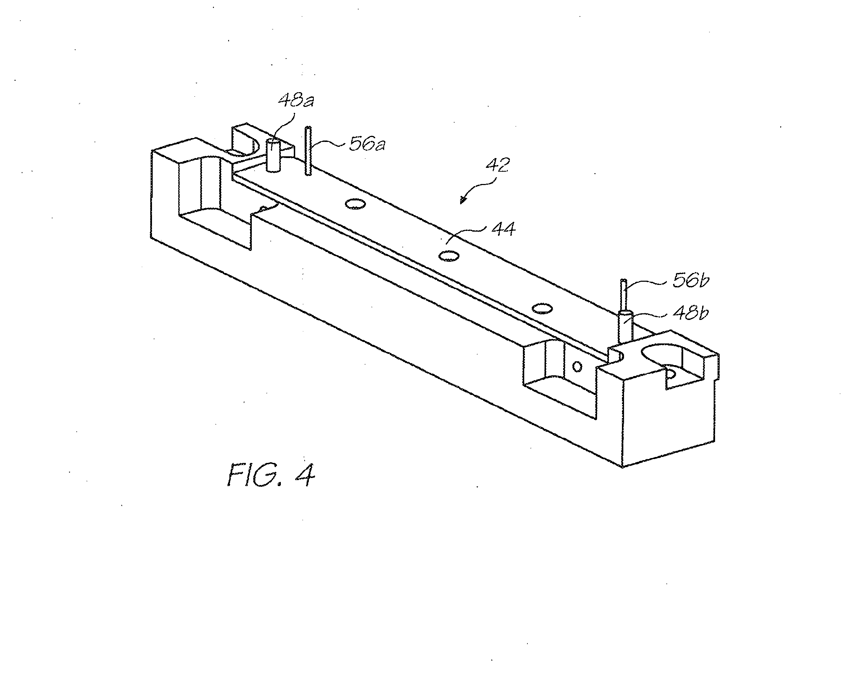

Figure 4 shows the carriage 42 and the nest 44 in detail. The nest 44 defines an upwardly facing recess in which the printhead assembly 14 can be rested. A pair of locating pegs 48a, b extend upwardly from the base of the nest 44 and are spaced apart to correspond to complementary guide holes 50a, b defined in the printhead assembly 14 (see Figure 1). In use, the operator places the printhead assembly 14 in the nest 44 so that the locating pegs 48a, b extend through the guide holes 50a, b.

Furthermore, a pair of locating pins 56a,b extend upwardly from the base of the nest 44 and are spaced apart to correspond to: complementary guide holes 52a,b defined in the printhead assembly 14; and complementary guide holes 54a,b defined in the PCB 12 (see Figure 1). In use, the operator places the printhead assembly 14 in the nest 44 so that the locating pins 56a, b extend through the guide holes 52a, b. In turn, the operator places the PCB 12 on the printhead assembly 14, with the adhesive on its underside, so that the locating pins 56a, b extend through the guide holes 54a, b. The bonding device 10 can then bond the PCB 12 and printhead assembly 14 together.

Returning to Figure 3, the movable bonding parts 21 further include a pneumatically driven vertical heated platen assembly 58, a vertical clamping assembly 60, a vertical forming bar assembly 62 and a horizontal heated platen assembly 64.

The vertical clamping assembly 60 and forming bar assembly 62 are of like construction. The vertical clamping assembly 60 includes a pneumatic actuator 65 which is fixed within the cabinet 20, and a movable clamp 66 which is constrained to reciprocate rectilinearly upon actuation of the actuator 65. Similarly, the forming bar assembly 62 includes a pneumatic actuator 68 which is fixed within the cabinet 20, and a movable bar 70 (or member) which is constrained to reciprocate rectilinearly upon actuation of the actuator 68. In use, the forming bar assembly 62 forms a bending mechanism for bending the flexible PCB 12.

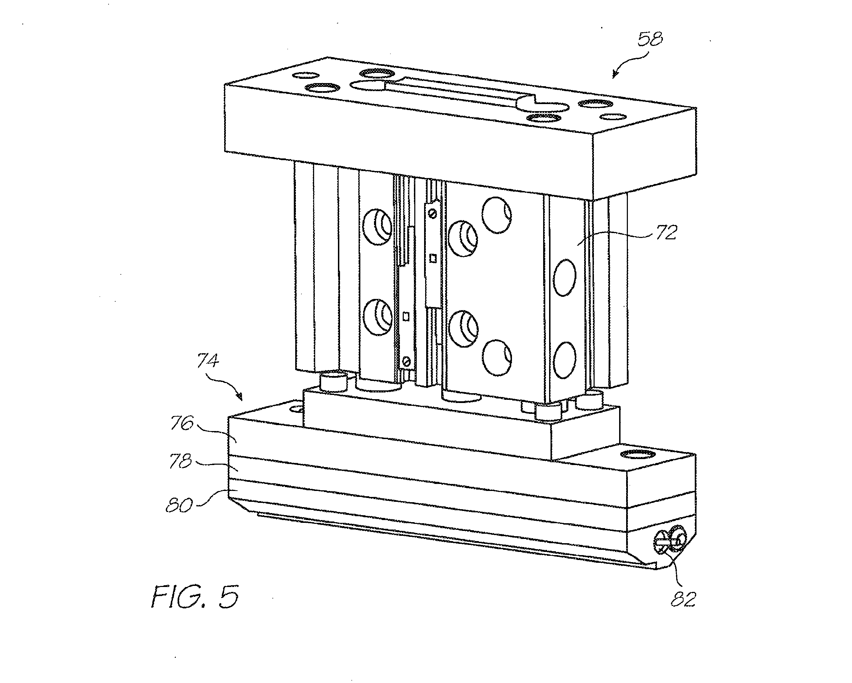

Figure 5 shows the vertical heated platen assembly 58 in detail. The heated platen assembly 58 includes a pneumatic actuator 72 fixed within the cabinet 20, and a heater assembly 74 which is constrained to reciprocate rectilinearly upon actuation of the actuator 72. The heater assembly 74 can move along a vertical path to bond the flexible PCB 12 to the printhead 18 with adhesive on the underside of the PCB 12.

The heater assembly 74 includes a steel platen 76, a thermal insulation sheet 78 mounted to the steel platen 76, and a thermally conductive brass platen 80 mounted to the insulation sheet 78. The brass platen 80 tapers to an apex at its base for engagement with the PCB 12. The brass platen defines an internal chamber in which a replaceable heater cartridge 82 is located.

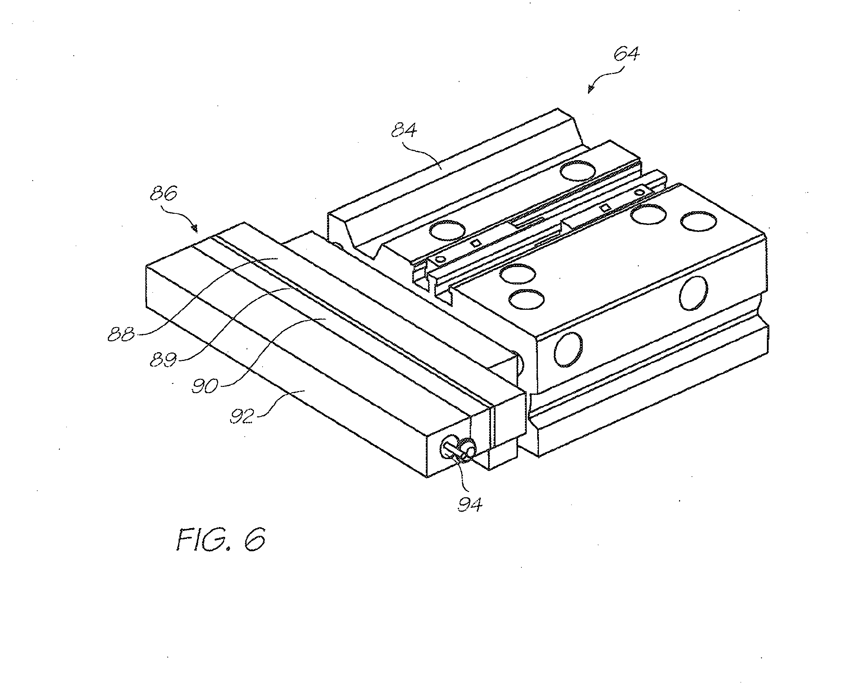

Figure 6 shows the horizontal heated platen assembly 64 in detail. The heated platen assembly 64 includes a pneumatic actuator 84 fixed within the cabinet 20, and a heater assembly 86 which is constrained to reciprocate rectilinearly upon actuation of the actuator 84. The heater assembly 86 can move along a substantially horizontal path to mechanically bond the flexible PCB 12 to the printhead carrier 16 with adhesive on the underside of the PCB 12.

The heater assembly 86 includes a steel platen 88, a silicone sheet 89 mounted to the steel platen 88, a thermal insulation sheet 90 mounted to the silicone sheet 89, and a thermally conductive brass platen 92 mounted to the insulation sheet 90. The brass platen 92 defines a substantially flat engagement surface. The brass platen 92 further defines an internal chamber in which a replaceable heater cartridge 94 is located.

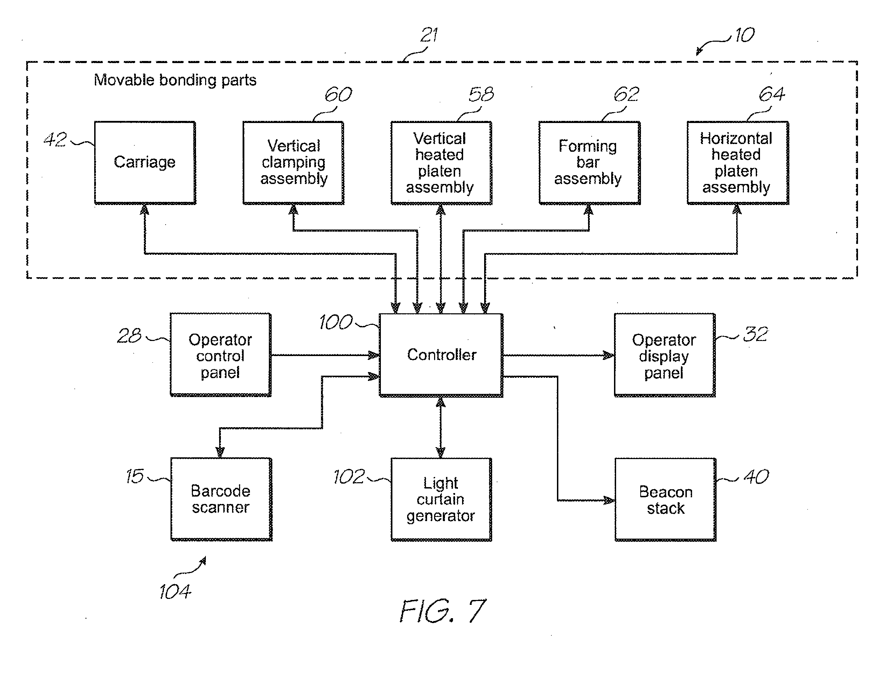

Figure 7 shows a block diagram of the bonding device 10. The bonding device 10 includes a central control system or controller 100 for controlling the operations of the bonding device 10. The controller 100 includes one or more processors and electronic interface circuitry for interfacing with the peripheral components.

The controller 100 controls the operation of the pneumatic movable bonding parts 21, as described in detail below, and receives feedback from each of those parts. The controller 100 further receives inputs from the operator control panel 28 as previously described, and displays information using the operator display panel 32 and the beacon stack 40. The controller 100 further controls a light curtain generator 102 to generate the light curtain 46 (Figure 3), and is configured to cease any movement of the movable bonding parts 21 responsive to a breach of the light curtain 46 as previously described. The controller 100 further controls the barcode scanner 15 of an authentication system 104 to authenticate the printhead assembly 14 as previously described.

Software is typically provided on a media, such as a magnetic or optical disk or solid state memory, which contains computer readable instructions for execution by the controller 100 to thereby perform the automated steps of the proceeding method 110.

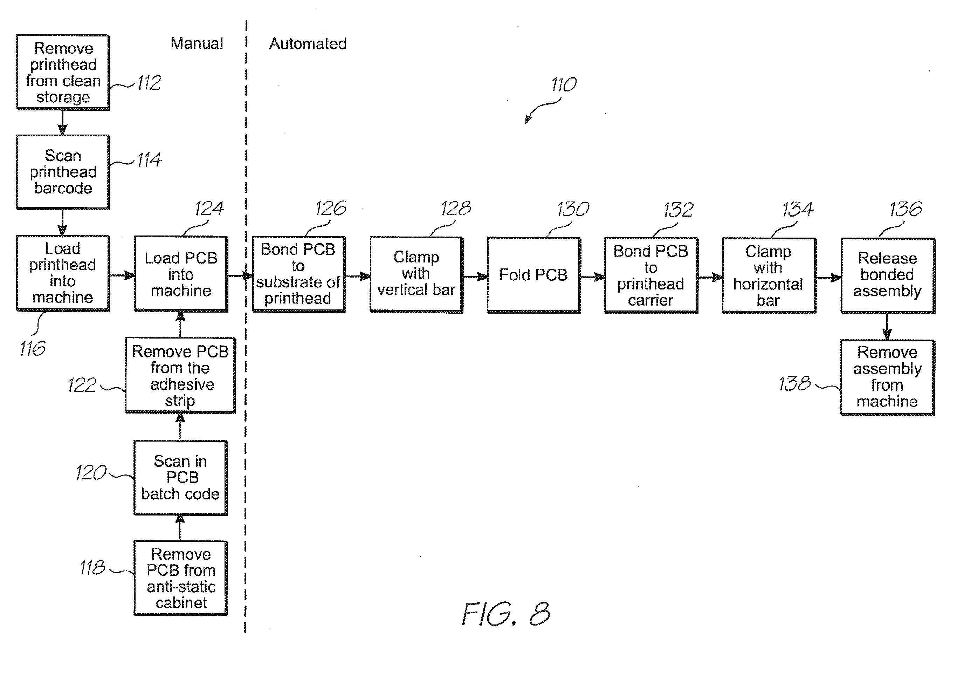

A method 110 for bonding the flexible PCB 12 to the printhead assembly 14 is now described in detail below with reference to Figure 8. The method 110 includes manual setup steps which the operator can perform in parallel and automated bonding steps which can be sequentially performed by the bonding device 10.

At step 112, the operator removes the printhead assembly 14 from a clean storage facility.

At step 114, the operator holds a printhead barcode borne by the printhead assembly 14 in register with the barcode scanner 15 of the authentication system 104. The operator then presses the SCAN press button 30b of the operator control panel 28 to scan the printhead barcode. The controller 100 compares the identity of the scanned printhead barcode with a list of valid printhead barcodes stored in memory and authenticates the printhead assembly 14 upon detecting a match.

At step 116, the operator loads the authenticated printhead assembly 14 into the nest 44 of the carriage 42. The carriage 42 is located external to the internal space 22 of the cabinet 20 as shown in Figure 3. As previously described, the locating pegs 48a,b and locating pins 56a,b extending from the nest 44 (Figure 4) are inserted into respective guide holes 50a,b and guide holes 52a,b defined in the printhead assembly 14 (Figure 1).

At step 118, the operator manually removes the flexible PCB 12 from an anti-static storage cabinet.

At step 120, the operator holds a PCB barcode borne by the PCB 12 in register with the barcode scanner 15 of the authentication system 104. The operator then presses the SCAN press button 30b of the operator control panel 28 to scan the PCB barcode. The controller 100 compares the identity of the scanned PCB barcode with a list of valid PCB barcodes stored in memory and authenticates the PCB 12 upon detecting a match.

At step 122, the operator peels a protective backing strip from the authentic PCB 12 to reveal an exposed adhesive on the underside of the PCB 12.

At step 124, the operator loads the authentic PCB 12 onto the carriage 42 with the adhesive facing downwards toward the previously loaded printhead assembly 14. As previously described, the locating pins 56a, b extending from the nest 44 (Figure 4) are inserted into respective guide holes 54a, b defined in the PCB 12 (Figure 1).

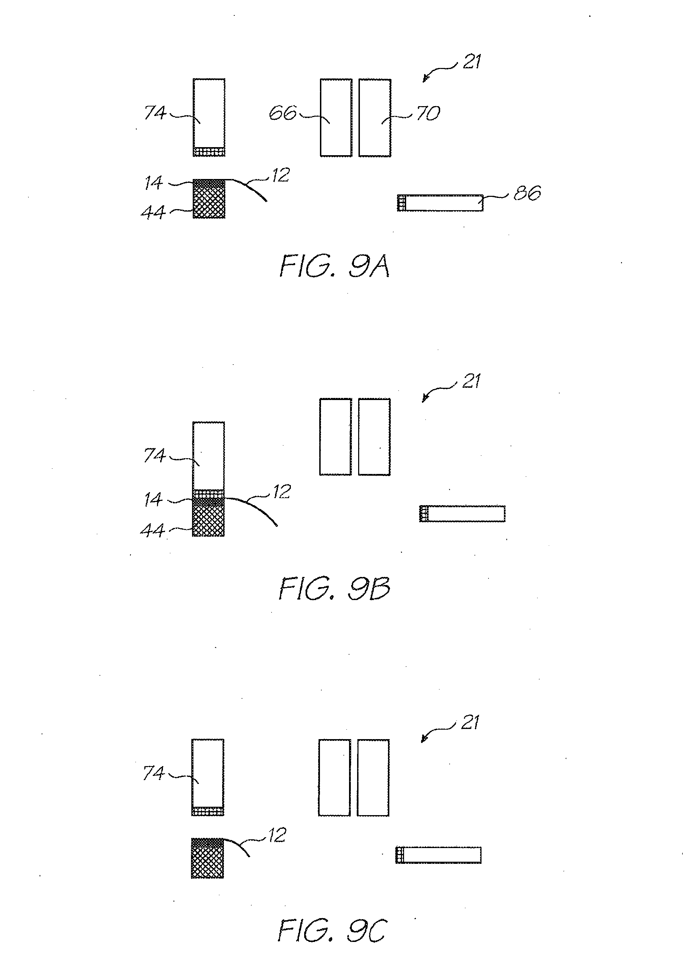

At step 126, the operator initiates bonding of the PCB 12 to the printhead assembly 14 with the bonding device 10. The operator concurrently presses the START buttons 30a, 30e with respective hands and the controller 100 moves the nest into the internal space 22 of the cabinet 20 as shown in Figure 9A. Subsequently, the controller 100 controls the light curtain generator 102 to generate the light curtain 46 across the front opening of the cabinet 20 (Figure 3).

The controller 100 controls the heater cartridge 82 at the tip of the vertical heater assembly 74 to be heated. As shown in Figure 9B, the controller 100 actuates the pneumatic actuator 72 of the vertical heated platen assembly 58 so that the heater assembly 74 and nest 44 compress the printhead assembly 14 and PCB 12. The heater cartridge 82 is heated for a predetermined period to ensure that the PCB 12 is bonded to a substrate of the printhead 18 with the adhesive. As shown in Figure 9C, the controller 100 then actuates the pneumatic actuator 72 of the vertical heated platen assembly 58 so that the heater assembly 74 is withdrawn from the PCB 12.

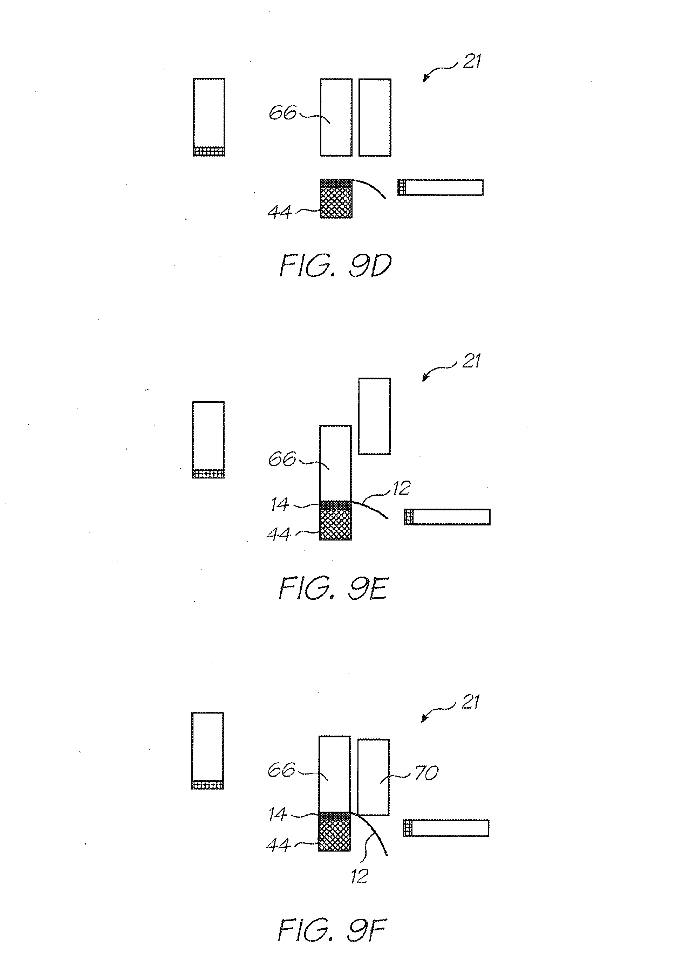

At step 128 of Figure 8, the controller 100 controls the carriage 42 to move the nest 44 in register with the movable clamp 66 of the vertical clamping assembly 60 as shown in Figure 9D. The controller 100 actuates the pneumatic actuator 65 of the vertical clamping assembly 60 so that the printhead assembly 14 and PCB 12 are compressed between the nest 44 and clamp 66 as shown in Figure 9E.

At step 130 of Figure 8, the controller 100 actuates the pneumatic actuator 68 of the forming bar assembly 62 so that the movable bar 70 moves vertically downward and folds (or bends) the PCB 12 downwardly as shown in Figure 9F.

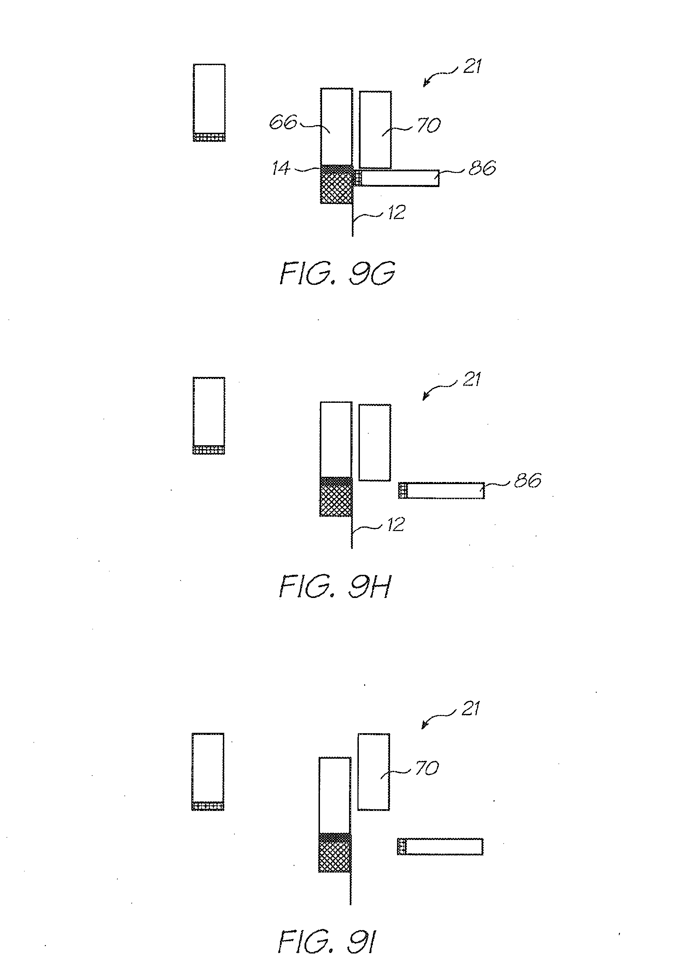

At step 132 of Figure 8, the controller 100 controls the heater cartridge 94 at the tip of the horizontal heater assembly 86 to be heated. As shown in Figure 9G, the controller 100 actuates the pneumatic actuator 84 of the horizontal heated platen assembly 64 so that the heater assembly 86 presses the bent PCB 12 against the printhead carrier 16 of the printhead assembly 14. The heater cartridge 94 is heated for a predetermined period to ensure that the PCB 12 is firmly bonded to the printhead carrier 16 with the adhesive. As shown in Figure 9H, the controller 100 then actuates the pneumatic actuator 84 of the horizontal heated platen assembly 64 so that the heater assembly 86 is withdrawn from the PCB 12.

At step 134 of Figure 8, a horizontal clamp in the form of the brass platen 92 clamps against the PCB 12 to compress the bonded PCB 12 between the printhead carrier 16 and brass platen 92 until the adhesive is set.

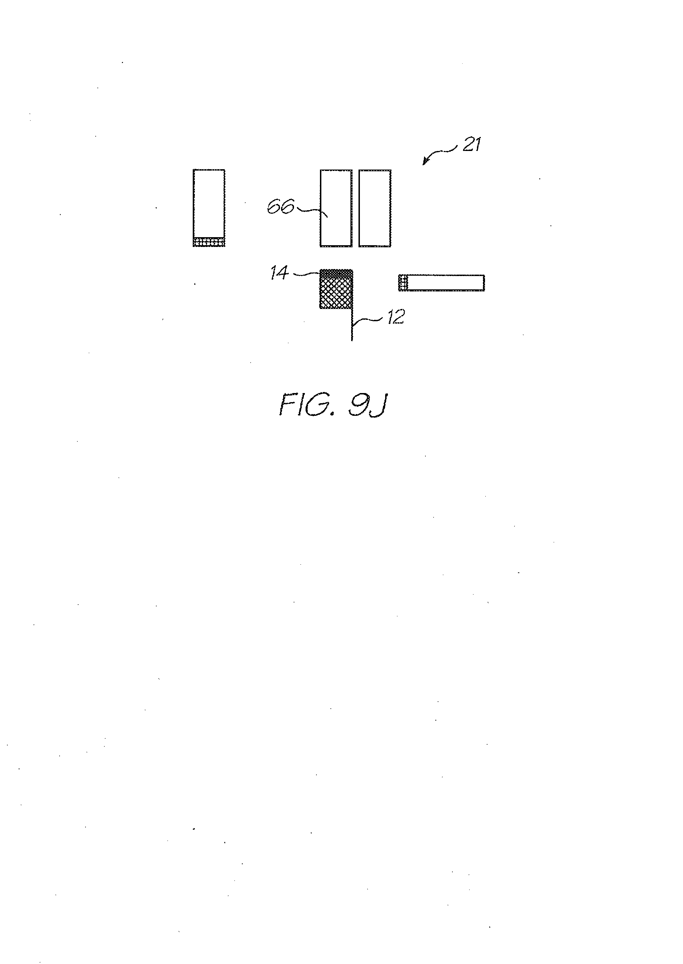

At step 136 of Figure 8, the controller 100 actuates the pneumatic actuator 68 of the forming bar assembly 62 so that the movable bar 70 moves vertically upwards as shown in Figure 9I. Subsequently, the controller 100 actuates the pneumatic actuator 65 of the vertical clamping assembly 60 so that the clamp 66 moves vertically upwards as shown in Figure 9J and thereby releases the bonded assembly from compression.

At step 138 of Figure 8, the controller 100 controls the light curtain generator 102 to disarm the light curtain 46 and moves the nest 44 out from the internal space 22 of the cabinet 20 to the position shown in Figure 3. The controller 100 controls the beacon stack 40 to signal that the bonding process is complete and the operator can then freely remove the bonded assembly from the nest 44. A manual visual inspection of the bonded assembly can then be performed by the operator.

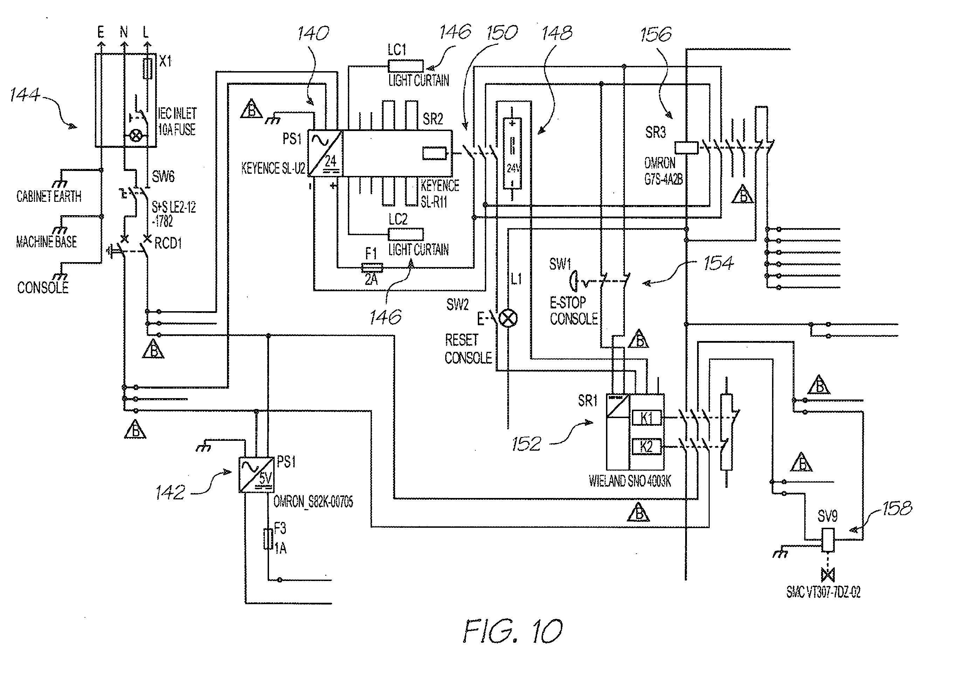

Figure 10 shows a circuit diagram of a power and safety arrangement of the bonding device 10. With reference to the previous drawings, unless otherwise indicated, like reference numerals refer to like parts.

Broadly, a 24 Volt power supply is indicated at 140. A 5 Volt power supply is indicated at 142. The power supplies 140, 142 are connected to a fuse arrangement 144.

In this diagram, the light curtain emitter and receiver or light curtain is indicated at 146. The light curtain 146 is connected to a light curtain safety relay 148 that acts to cut the 24 Volt power supply 140 with a switch 150.

A safety mute relay is indicated at 152. The relay 152 is configured to receive a signal from a PLC (described below) to cut off the 24 Volt power supply 142 to the heating arrangement (described below) and to the various pneumatic actuators (also described below).

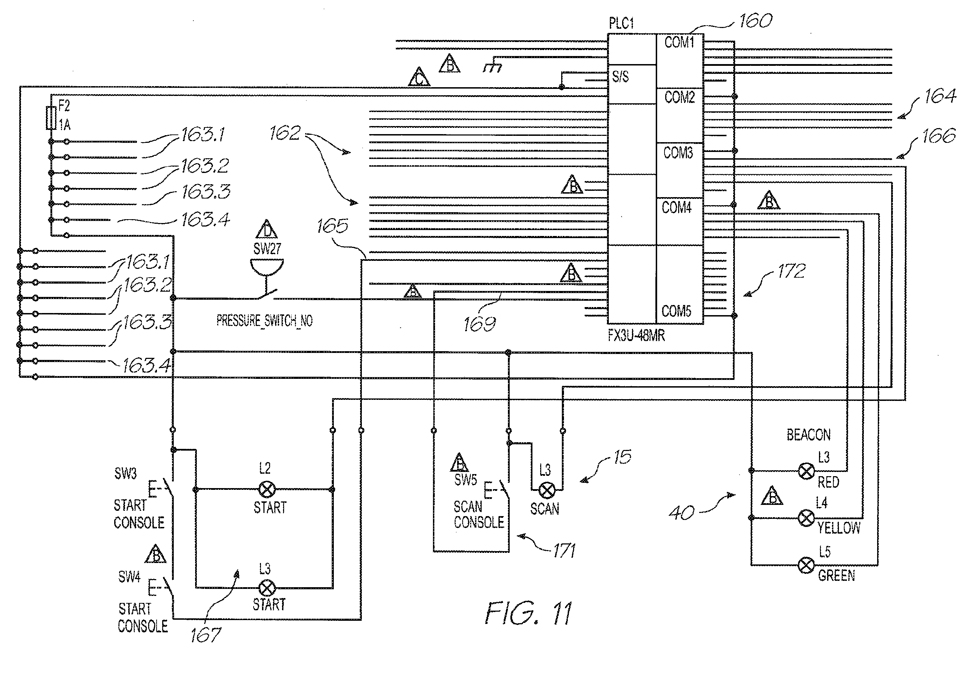

The emergency stop buttons 30c are indicated at 154 in Figure 11. The buttons 154 are connected to a further safety relay 156. The relay 156 is connected to both the power supplies 140, 142 to cut power when actuated. The relay 156 is also connected to a safety valve 158 for the pneumatic system of the bonding device 10.

Figure 11 shows a PLC 160 that forms part of the controller 100. The PLC 160 is programmed to control operation of the various components to achieve the method steps described above.

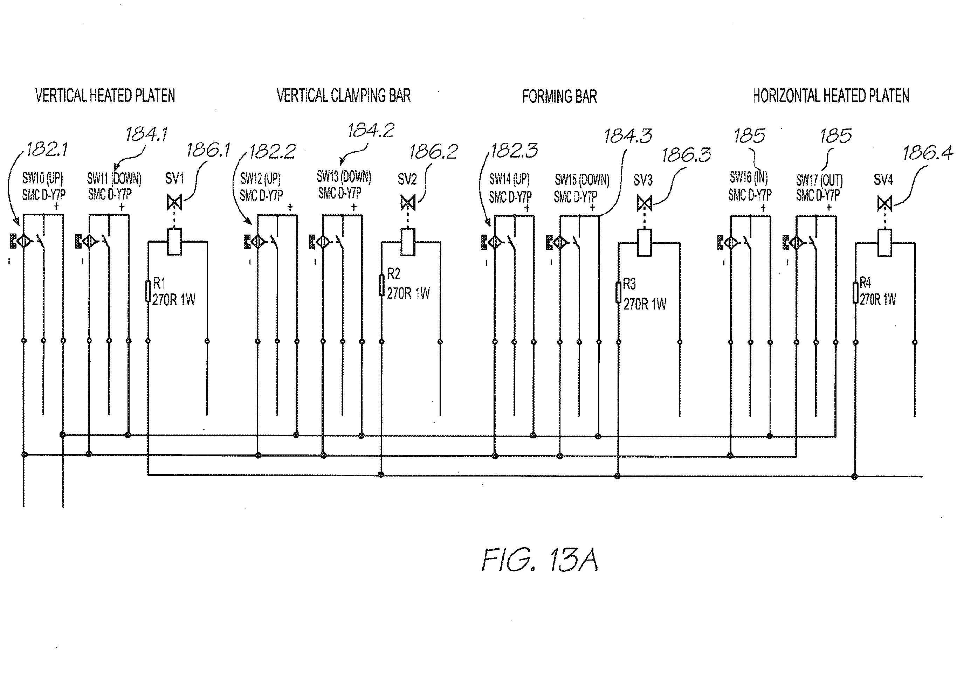

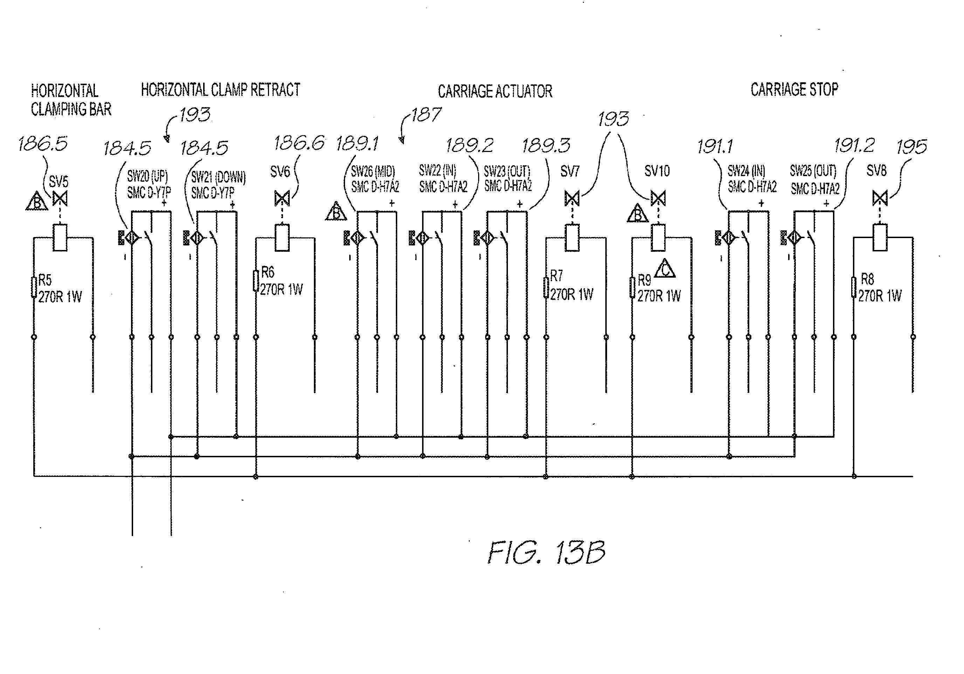

The PLC 160 communicates with solenoid valves (described with reference to Figure 13) to operate of the vertical platen and clamping assemblies 58, 60, the vertical forming bar assembly 62 and the horizontal heated platen assembly 64 at 162.

At 164, the PLC 160 communicates with solenoid valves to operate the horizontal bar 70, the clamp 66 and the carriage 42.

At 166, the PLC 160 communicates with the mute relay 152, a start lamp 168, a carriage in signal and a scan lamp 170.

At 172, the PLC 160 communicates with the beacon stack 40.

The PLC 160 also communicates with solid state switches (Figure 13A and 13B) at 163.1 and with pressure sensors at 163.2 for the necessary feedback control.

The PLC 160 communicates with the optical barcode scanner 15 at 163.3 and with an Ethernet connection at 163.4.

At 165, the PLC 160 communicates with start buttons 167.

At 169, the PLC 160 communicates with a scan console 171 of the scanner 15.

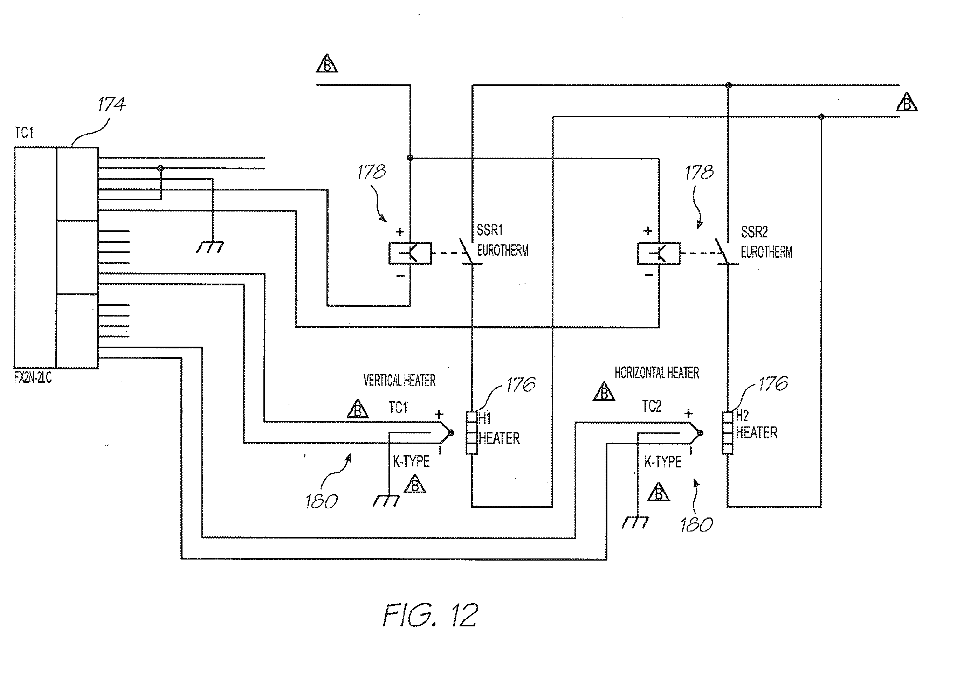

Figure 12 shows a temperature controller 174 that is configured to control the temperature generated by the heater assemblies 74, 86. The replaceable heater cartridges are indicated at 176. Switches 178 for the heater cartridges 176 are connected to the controller 174. Thermocouples 180 are connected to the controller 174 and are positioned to sense the temperature of the cartridges 176.

Figures 13A and 13B show circuit diagrams of the electrical components associated with the pneumatic system of the bonding device 10.

A circuit for the vertical heated platen assembly 58 includes an "up" solid state limit switch 182.1 and a "down" solid state limit switch. A solenoid valve 186.1 actuates the assembly 58.

A circuit for the vertical clamping assembly 60 includes an "up" solid state limit switch 182.2 and a "down" solid state limit switch 184.2. A solenoid valve 186.2 actuates the assembly 60.

A circuit for the forming bar assembly 62 includes an "up" solid state limit switch 182.3 and a "down" solid state limit switch 184.3. A solenoid valve 186.3 actuates the forming bar assembly 62.

A circuit for the horizontal heated platen assembly 64 includes a pair of limit switches 185. A solenoid valve 186.4 actuates the platen assembly 64.

A circuit for the heater assembly 86 including the brass platen 92 includes a solenoid valve 186.5 to actuate the heater assembly 86.

A circuit for retracting the horizontal heated platen assembly 64 includes a pair of limit switches 184.5. A solenoid valve 186.6 actuates the platen assembly 64.

A circuit for a carriage actuator includes a mid-limit switch 189.1, an "in" limit switch 189.2 and an "out" limit switch 189.3. A pair of solenoid valves 193 provides the necessary actuation.

A circuit for the carriage 42 includes an "in" limit switch 191.1 and an "out" limit switch 191.2. A solenoid valve 195 is provided for displacement of the carriage 42.

As described above, the switches and the solenoid valves are connected to the PLC 160 to facilitate control of the electrical components and thus the pneumatic circuit described below.

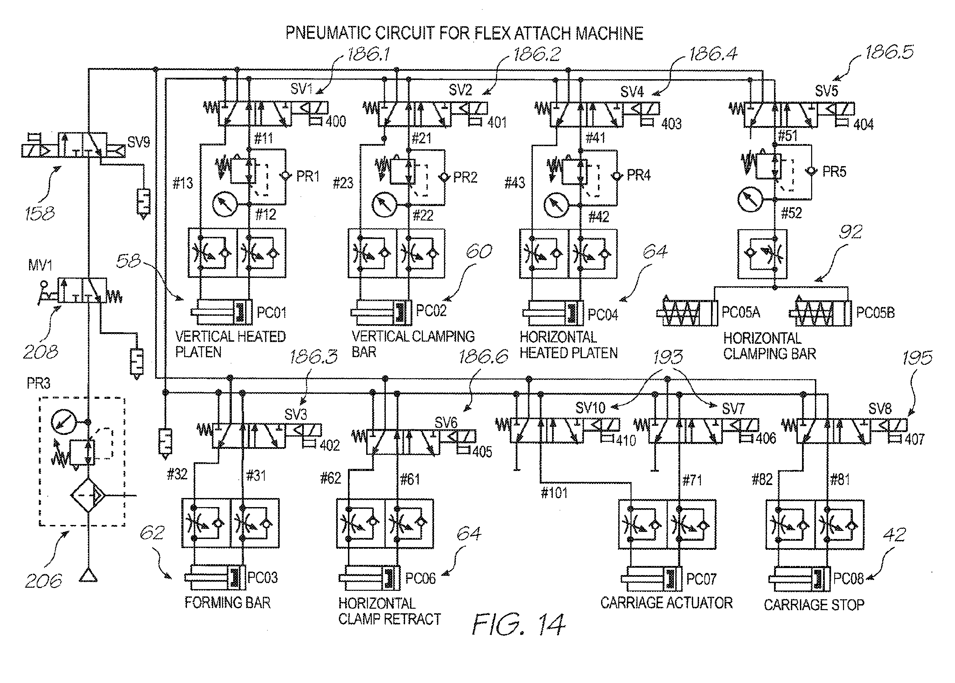

Figure 14 shows the pneumatic circuit or system referred to above. With reference to the previous drawings, like reference numerals refer to like parts, unless otherwise specified.

The circuit receives a pressurized air supply via, in series, a pressure regulator 206, a manual valve 208 and the safety valve 158.

The pressurized air supply is then delivered to via pressure regulators 216 to the various components described above.

A person skilled in the art will appreciate that many embodiments and variations can be made without departing from the ambit of the present invention.

In compliance with the statute, the invention has been described in language more or less specific to structural or methodical features. It is to be understood that the invention is not limited to specific features shown or described since the means herein described comprises preferred forms of putting the invention into effect. The invention is, therefore, claimed in any of its forms or modifications within the proper scope of the appended claims appropriately interpreted by those skilled in the art.

## Claims

1. A bonding device (10) for bonding a flexible printed circuit board (PCB) (12) to a printhead assembly (14), the printhead assembly having a printhead carrier (16) and an ink ejection printhead (18) carried by the carrier, the bonding device comprising:
a support structure assembly;
a first heater assembly (74) arranged on the support structure assembly to be movable along a first path and configured to bond the flexible PCB (12) to the printhead (18);
a second heater assembly (86) arranged on the support structure assembly to be movable along a second path and configured to bond the PCB to the printhead carrier; and
a control system to control operation of the heater assemblies,
**characterised in that**:
a bending mechanism (62) is arranged on the support structure assembly, wherein the control system controls operation of the bending mechanism so as to bend the PCB after bonding by the first heater assembly (74); and
the support structure assembly includes a cabinet (20), the heater assemblies and bending mechanism being located within an internal space (22) of the cabinet, the cabinet defining an access opening to facilitate access to the heater assemblies and bending mechanism within the internal space.

2. A bonding device as claimed in claim 1, wherein the heater assemblies are rectilinearly constrained to move along their respective paths.

3. A bonding device as claimed in claim 1, wherein the bending mechanism (62) includes a bending member (70) movable along a rectilinear path.

4. A bonding device as claimed in claim 1, wherein the control system includes an operator control panel (28) on the cabinet (20) and including a plurality of control actuators configured to control the operation of the bending mechanism and the heater assemblies, the control actuators including a pair of buttons (30a, 30e) and being configured to operate exclusively on concurrent depression of the buttons, the pair of buttons being spaced apart to ensure that an operator uses both hands to depress the buttons.

5. A bonding device as claimed in claim 4, in which the control system includes a stack of beacons (40) mounted to the cabinet (20), the control system being configured so that the beacons are illuminated in a plurality of different ways to represent corresponding operational conditions of the bonding device (10).

## Patentansprüche

1. Klebevorrichtung (10) zum Kleben einer flexiblen Leiterplatte (PCB) (12) an eine Druckkopfeinheit (14) wobei die Druckkopfeinheit einen Druckkopfträger (16) und einen Tintenausstoß-Druckkopf (18) aufweist, der vom Träger getragen wird, und wobei die Klebevorrichtung Folgendes umfasst:
eine Trägerstruktureinheit;
eine erste Heizeinheit (74), die so auf der Trägerstruktureinheit angeordnet ist, dass sie entlang eines ersten Pfads beweglich ist, und die so konfiguriert ist, dass sie die flexible Leiterplatte (12) an den Druckkopf (18) klebt;
eine zweite Heizeinheit (86), die so auf der Trägerstruktureinheit angeordnet ist, dass sie entlang eines zweiten Pfads beweglich ist, und die so konfiguriert ist, dass sie die flexible Leiterplatte an den Druckkopfträger klebt; und
ein Steuersystem, das den Betrieb der Heizeinheiten steuert,
**dadurch gekennzeichnet, dass**:
ein Biegemechanismus (62) auf der Trägerstruktureinheit angeordnet ist, wobei das Steuersystem den Betrieb des Biegemechanismus so steuert, dass die Leiterplatte nach dem Verkleben von der ersten Heizeinheit (74) gebogen wird; und
die Trägerstruktureinheit ein Gehäuse (20) umfasst, wobei die Heizeinheiten und der Biegemechanismus innerhalb eines Innenraums (22) des Gehäuses angeordnet sind, und wobei das Gehäuse eine Zugangsöffnung aufweist, um den Zugang zu den Heizeinheiten und dem Biegemechanismus im Innenraum zu erleichtern.

2. Klebevorrichtung nach Anspruch 1, wobei die Heizeinheiten geradlinig so eingeschränkt sind, dass sie sich entlang ihrer jeweiligen Pfade bewegen.

3. Klebevorrichtung nach Anspruch 1, wobei der Biegemechanismus (62) ein Biegeglied (70) umfasst, das sich entlang eines geradlinigen Pfads bewegen kann.

4. Klebevorrichtung nach Anspruch 1, wobei das Steuersystem eine Bediensteuertafel (28) auf dem Gehäuse (20) mit mehreren Steuerauslösern umfasst, die so konfiguriert sind, dass sie den Betrieb des Biegemechanismus und der Heizeinheiten steuern, wobei die Steuerauslöser ein Knopfpaar (30a, 30e) umfassen und so konfiguriert sind, dass nur bei gleichzeitigem Drücken der Köpfe Betrieb auslösen, wobei das Knopfpaar mit einem Abstand voneinander angeordnet ist, um zu gewährleisten, dass ein Bediener beim Drücken der Knöpfe beide Hände benutzt.

5. Klebevorrichtung nach Anspruch 4, wobei das Steuersystem einen Lichtsignalstapel (40) umfasst, der an dem Gehäuse (20) angebracht ist, und das Steuersystem so konfiguriert ist, dass die Lichtsignale auf mehrere verschiedene Weisen aufleuchten, um entsprechende Betriebsbedingungen der Klebevorrichtung (10) darzustellen.

## Revendications

1. Dispositif de soudage (10) destiné à souder un circuit imprimé (PCB) souple (12) sur un ensemble tête d'impression (14), l'ensemble tête d'impression ayant un élément porteur de tête d'impression (16) et une tête d'impression (18) à éjection d'encre portée par l'élément porteur, le dispositif de soudage comprenant :
un ensemble structure de support ;
un premier groupe chauffant (74) disposé sur l'ensemble structure de support de façon à pouvoir être déplacé le long d'un premier trajet et configuré pour souder le PCB souple (12) à la tête d'impression (18) ;
un second groupe chauffant (86) disposé sur l'ensemble structure de support de façon à pouvoir être déplacé le long d'un second trajet et configuré pour souder le PCB à l'élément porteur de tête d'impression ; et
un système de commande chargé de commander le fonctionnement des groupes chauffants,
**caractérisé en ce que** :
un mécanisme de cintrage (62) est disposé sur l'ensemble structure de support, le système de commande commandant le fonctionnement du mécanisme de cintrage de façon à cintrer le PCB après soudage par le premier groupe chauffant (74) ; et
l'ensemble structure de support comprend un coffret (20), les groupes chauffants et le mécanisme de cintrage étant situés dans un espace intérieur (22) du coffret, le coffret définissant une ouverture d'accès afin de faciliter l'accès aux groupes chauffants et au mécanisme de cintrage dans l'espace intérieur.

2. Dispositif de soudage tel que revendiqué par la revendication 1, dans lequel les groupes chauffants sont contraints de façon rectiligne à se déplacer le long de leurs trajets respectifs.

3. Dispositif de soudage tel que revendiqué par la revendication 1, dans lequel le mécanisme de cintrage (62) comprend un élément cintrant (70) pouvant être déplacé le long d'un trajet rectiligne.

4. Dispositif de soudage tel que revendiqué par la revendication 1, dans lequel le système de commande comprend un panneau de commande d'actionnement (28) sur le coffret (20) et inclut une pluralité d'actionneurs de commande configurés pour commander le fonctionnement du mécanisme de cintrage et des groupes chauffants, les actionneurs de commande incluant une paire de boutons (30a, 30e) et étant configurés pour fonctionner uniquement lorsque les boutons sont enfoncés simultanément, la paire de boutons étant espacée de façon à garantir qu'un opérateur doive utiliser ses deux mains pour appuyer sur les boutons.

5. Dispositif de soudage tel que revendiqué dans la revendication 4, dans lequel le système de commande comprend une colonne de balises lumineuses (40) montée sur le coffret (20), le système de commande étant configuré de façon à ce que les balises lumineuses s'éclairent de différentes manières pour représenter des états de fonctionnement correspondants du dispositif de soudage (10).
